# EUROPEAN PATENT SPECIFICATION

(11) **EP 3 057 227 B1**
(45) Date of publication and mention of the grant of the patent: **11.04.2018**
(21) Application number: 14871052.8
(22) Date of filing: 21.11.2014
(51) Int. Cl.: H02P 27/06, H02M 7/06, H02M 7/48, G01R 23/15, G01R 31/40

(54) **POWER SUPPLY FREQUENCY DETERMINATION DEVICE AND POWER SUPPLY FREQUENCY DETERMINATION METHOD**
VORRICHTUNG ZUR BESTIMMUNG EINER STROMVERSORGUNGSFREQUENZ UND VERFAHREN ZUR BESTIMMUNG EINER STROMVERSORGUNGSFREQUENZ
DISPOSITIF DE DÉTERMINATION DE FRÉQUENCE D'ALIMENTATION ÉLECTRIQUE ET PROCÉDÉ DE DÉTERMINATION DE FRÉQUENCE D'ALIMENTATION ÉLECTRIQUE

(30) Priority: 20.12.2013 JP 2013264307
(43) Date of publication of application: 17.08.2016
(73) Proprietor: MITSUBISHI HEAVY INDUSTRIES THERMAL SYSTEMS, LTD., Tokyo 108-8215 (JP)
(72) Inventor: AKITA, Jun, Tokyo 108-8215 (JP)
(74) Representative: Henkel, Breuer & Partner
(86) International application number: PCT/JP2014/080931
(87) International publication number: WO 2015/093230

(56) References cited:
- JP-A- S6 135 159
- JP-A- 2000 358 377
- JP-A- 2004 201 379
- JP-A- 2008 109 846
- JP-A- 2012 213 264
- JP-A- 2013 066 299
- JP-A- 2013 132 131
- KR-A- 20060 022 945
- US-A1- 2003 219 086

## Description

### Technical Field

The present invention relates to a power supply frequency determination device and a power supply frequency determination method.

### Background Art

In recent years, pulse amplitude modulation (PAM) control has been performed as control for motors used in air conditioning devices or the like.

In PAM control, in order to reduce the higher harmonic components of an input current, a pulse corresponding to the frequency of AC power is output. Therefore, in PAM control, it is necessary to correctly determine the frequency of AC power.

As an example of a frequency detection circuit that detects the frequency of AC power, in Patent Document 1, it is disclosed that a value obtained by calculating the time of one cycle on the basis of a pulsating voltage involved in detection performed by a pulsating voltage detection means, multiplying by 6 for example, and taking the inverse is treated as the power supply frequency.

This kind of frequency detection circuit performs a determination as to the frequency of AC power, for example, 50 Hz or 60 Hz, by measuring zero-cross intervals of AC power at the same time as the supply of AC power to a device to which AC power for an air conditioning device or the like is supplied. Patent Document 2 discloses a frequency determination method based on the DC ripple. Patent Document 3 discloses jitter identification in a signal based on the output sample sequence.

### Citation List

### Patent Literature

Patent Document 1: Japanese Unexamined Patent Application Publication No. 2013-66299A
Patent Document 2: KR 2006 0022945 A
Patent Document 3: US 2003/219086 A1

### Summary of Invention

### Technical Problem

A frequency detection circuit is configured with a voltage-dividing resistor. Therefore, in the frequency detection circuit, a voltage is applied to the voltage-dividing resistor even in a standby state in which a frequency is not detected. Therefore, in the frequency detection circuit, power is consumed by the voltage-dividing resistor even in a standby state.

Therefore, in order to reduce the standby power of the frequency detection circuit, detection of the frequency of AC power by the frequency detection circuit has been performed at the same time as turning on a power supply for a device. Then, after the determination of the frequency, power consumption by the frequency detection circuit has been prevented by disconnecting the frequency detection circuit by means of a relay.

In this way, in the determination of the frequency of AC power for which a frequency detection circuit is used, complex processing is required when supplying AC power for a device.

The present invention has been devised in view of such circumstances, and an object thereof is to provide a power supply frequency determination device and a power supply frequency determination method, with which the frequency of AC power can be determined without separately providing a frequency detection circuit.

### Solution to Problem

In order to solve the above-described problem, the power supply frequency determination device and the power supply frequency determination method of the present invention employ the following means.

A power supply frequency determination device according to claim 1 of the present invention is provided with: a voltage detection means that detects a DC voltage converted from AC power by a converter; a voltage determination means that determines whether or not the DC voltage detected by the voltage detection means enters within a predetermined reference voltage range, at time intervals corresponding to an assumed value for the frequency of the AC power; and a frequency determination means that determines the validity of the assumed value, based on the number of times that the DC voltage is determined as having entered within the reference voltage range by the voltage determination means, within a time range corresponding to the assumed value.

According to the present configuration, a DC voltage converted from AC power by a converter is detected by the voltage detection means. The DC voltage converted from the AC power fluctuates by a predetermined ripple width.

Then, by the voltage determination means, a determination is made as to whether or not the fluctuating DC voltage enters within a predetermined reference voltage range, at time intervals corresponding to an assumed value for the frequency of the AC power. For example, in the case where the assumed value for the frequency is 50 Hz, the determination by the voltage determination means is performed at time intervals of 10 msec. The DC voltage fluctuates by the predetermined ripple width, and therefore sometimes enters within the reference voltage range sometimes does not.

In addition, the determination by the voltage determination means is repeated at each time interval corresponding to the assumed value, within a time range corresponding to the assumed value for the frequency. For example, in the case where the assumed value for the frequency is 50 Hz, the determination by the voltage determination means is performed every 10 msec within a time range of 100 msec. In other words, the determination by the voltage determination means is performed 10 times.

When the time range ends, the validity of the assumed value for the frequency is determined by the frequency determination means on the basis of the number of times that the DC voltage is determined as having entered within the reference voltage range. For example, the assumed value for the frequency is taken as 50 Hz. In this case, if the DC voltage enters within the reference voltage range five times or more within the time range of 100 msec, the actual AC power is also determined as being 50 Hz. It should be noted that, when the reference voltage range is wide, the number of times that the DC voltage enters within the reference voltage range also increases. Therefore, the number of times with which the assumed value for the frequency is treated as being correct is predetermined in accordance with the width of the reference voltage range.

However, the actual AC power frequency is taken as being 60 Hz even when the assumed value for the frequency is assumed to be 50 Hz. In this case, the number of times that the DC voltage enters within the reference voltage range decreases at time intervals for which the assumed value for the frequency is taken as 50 Hz. The reason being because ripples of the DC voltage fluctuate at cycles of 60 Hz, and therefore the time intervals at which the DC voltage is determined and the fluctuation cycles of the ripples of the DC voltage deviate. Therefore, the AC power is determined as not being 50 Hz.

In this way, in the present configuration, the frequency of the AC power is assumed in advance, and the validity of that assumed frequency is determined based on a DC voltage converted from an AC voltage. Consequently, in the present configuration, the frequency of the AC power can be determined without separately providing a frequency detection circuit.

In claim 1 it is preferable that the reference voltage range be a range for which a predetermined reference voltage is taken as a determination value and the allowable width of the determination value is taken as a predetermined ratio of the ripple width of the DC voltage.

According to the present configuration, a predetermined reference voltage ± a predetermined ratio of the ripple width is taken as the reference voltage range. It should be noted that the predetermined ratio is from 10% to 20% of the ripple width. Consequently, in the present configuration, appropriate values that correspond to the DC voltage fluctuating within the reference voltage range are possible.

In claim 1 it is preferable that the voltage detection means be provided between the converter that converts the AC power into DC power and an inverter that converts and supplies the DC power to a motor, and the voltage determination means performs a determination while the rotational speed of the motor is made constant.

According to the present configuration, in the case where the rotational speed of the motor is constant, rising or falling of the input voltage to the motor does not occur, and the input current is also in a stable state. Therefore, in the present configuration, the frequency of the AC power can be determined more accurately.

A power supply frequency determination method according to claim 4 of the present invention includes: a first step in which a DC voltage converted from AC power by a converter is detected; a second step in which whether or not the detected DC voltage enters within a predetermined reference voltage range is determined at time intervals corresponding to an assumed value for a frequency of the AC power; and a third step in which the validity of the assumed value is determined based on the number of times that the detected DC voltage is determined as having entered within the reference voltage range, within a time range corresponding to the frequency.

### Advantageous Effects of Invention

According to the present invention, there is an advantageous effect in that the frequency of AC power can be determined without separately providing a frequency detection circuit.

### Brief Description of Drawings

FIG. 1 is a configuration diagram of a power supply device for a motor according to an embodiment of the present invention.
FIG. 2 is a functional block diagram of a power supply frequency determination function according to an embodiment of the present invention.
FIG. 3 is a flowchart depicting the flow of power supply frequency determination processing according to an embodiment of the present invention.
FIG. 4 is a graph depicting fluctuations in DC voltage in the case where an assumed frequency according to an embodiment of the present invention is correct.
FIG. 5 is a graph depicting fluctuations in DC voltage in the case where an assumed frequency according to an embodiment of the present invention is not correct.
FIG. 6 is a drawing depicting frequency determination timings according to an embodiment of the present invention.

### Description of Embodiments

Hereinafter, a power supply frequency determination device and a power supply frequency determination method according to the present invention will be described with reference to the drawings.

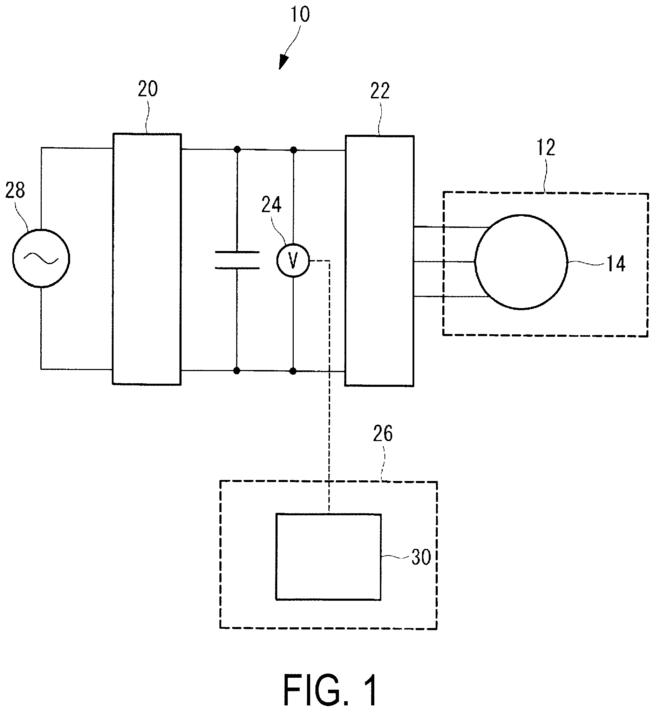

A power supply device 10 according to the present embodiment will be described with reference to FIG. 1.

The power supply device 10 according to the present embodiment supplies power to a motor 14 provided in a compressor 12 of an air conditioner. Also, the power supply device 10 is provided with a converter 20, an inverter 22, a voltage detection unit 24, and an air conditioner control device 26.

The converter 20 has one end connected to an AC power supply 28 and the other end connected to the inverter 22. Also, the converter 20 converts AC power (single-phase AC power) supplied from the AC power supply 28 into DC power, and feeds the DC power to the inverter 22.

The inverter 22 has one end connected to the converter 20 and the other end connected to the motor 14. The inverter 22 converts the DC power output from the converter 20 into three-phase AC power, and supplies the three-phase AC power to the motor 14.

The voltage detection unit 24 detects a DC voltage converted from the AC power by the converter 20. The DC voltage converted by the converter 20 fluctuates by a predetermined ripple width.

The air conditioner control device 26 performs various control for the inverter 22 and the air conditioner.

The air conditioner control device 26 is a microcomputer, and is configured from, for example, a central processing unit (CPU) and a computer-readable recording medium such as a random access memory (RAM) and a read only memory (ROM). Also, a sequence of processing for realizing the various functions is, as an example, recorded on a recording medium or the like in the form of a program, and the various functions are realized by the CPU reading out this program to the RAM or the like and executing information processing/calculation processing. It should be noted that, for example, a mode in which the program is installed in advance in the ROM or some other storage medium, a mode in which the program is provided in the state of being stored on a computer-readable storage medium, or a mode in which the program is distributed via a wired or wireless communication means may be applied. The computer-readable storage medium is, for example, a magnetic disk, a magneto-optical disk, a CD-ROM, a DVD-ROM, or a semiconductor memory.

The air conditioner control device 26, as control for the inverter 22, generates, for each phase, a gate driving signal (PWM signal) with which the rotational speed of the motor 14 is made to match a motor rotational speed instruction provided from a higher-order control device (not depicted). Also, due to the gate driving signal being provided to a switching element corresponding to each phase of the inverter 22, the inverter 22 is controlled, and a desired three-phase AC voltage is supplied to the motor 14.

Moreover, as control for the rotational speed of the motor 14, pulse amplitude modulation (PAM) control is performed.

Furthermore, the air conditioner control device 26 according to the present embodiment is provided with a power supply frequency determination device 30 (power supply frequency determination function).

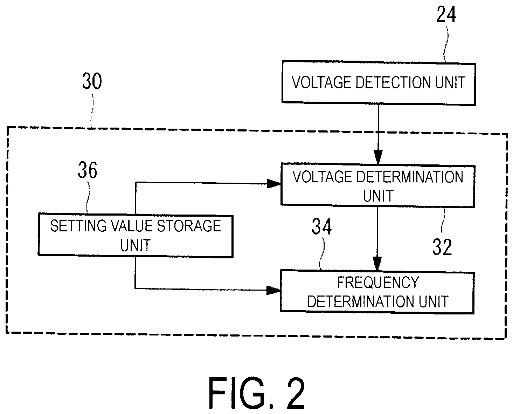

FIG. 2 is a functional block diagram of the power supply frequency determination device 30.

The power supply frequency determination device 30 is provided with a voltage determination unit 32, a frequency determination unit 34, and a setting value storage unit 36.

A DC voltage detected by the voltage detection unit 24 is A/D converted and input to the voltage determination unit 32. Then, the voltage detection unit 24 determines whether or not the fluctuating DC voltage enters within a predetermined reference voltage range, at time intervals corresponding to an assumed value for the frequency of the AC power (hereinafter, referred to as the "assumed frequency"). In other words, since the frequency of the AC power is not known, the power supply frequency determination function assumes the frequency of the AC power in advance, and determines the validity of the assumed frequency.

In the following description, a time interval corresponding to the assumed frequency is referred to as a voltage determination time interval.

The frequency determination unit 34 determines the validity of the assumed frequency on the basis of the number of times that the DC voltage is determined as having entered within the reference voltage range by the voltage determination unit 32, within the voltage determination time interval.

It should be noted that, in the following description, a time range corresponding to the assumed frequency is referred to as a frequency determination time range.

The setting value storage unit 36 stores various setting values such as the assumed frequency, the reference voltage range, the voltage determination time interval, and the frequency determination time range. It should be noted that the setting value storage unit 36 is a predetermined region of a recording medium provided in the air conditioner control device 26.

The voltage determination time interval and the frequency determination time range are predetermined according to the assumed frequency as depicted in the example of Table 1.

**[Table 1]**

| Assumed frequency | Voltage determination time interval | Frequency determination time range |
|---|---|---|
| 50 Hz | 10 msec | 100 msec |
| 60 Hz | 8.3 msec | 83 msec |

The reference voltage range is a range for which a predetermined reference voltage is taken as a determination value, and the allowable width of the determination value is taken as a predetermined ratio of the ripple width of the DC voltage. The predetermined ratio is from 10% to 20% of the ripple width, for example. In other words, the reference voltage range is from 10% to 20% of the reference voltage ± the ripple width, for example.

It should be noted that, in the present embodiment, the assumed frequency is taken as 50 Hz as an example.

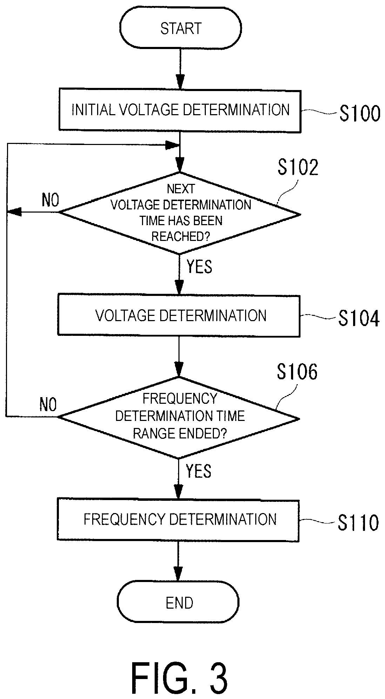

FIG. 3 is a flowchart depicting the flow of power supply frequency determination processing executed by the air conditioner control device 26. A program relating to power supply frequency determination processing is stored in advance in a predetermined region of the recording medium provided in the air conditioner control device 26.

In the power supply frequency determination processing, the frequency of the AC power is assumed in advance, and the validity of that assumed frequency is determined based on the DC voltage converted from the AC voltage. It should be noted that the power supply frequency determination processing is executed at a predetermined timing (hereinafter, referred to as the "frequency determination timing"). The frequency determination timing will be described later.

The voltage detection unit 24 continues detecting the DC voltage, and continues outputting the detected DC voltage to the air conditioner control device 26, until the power supply frequency determination processing is started and ends. Furthermore, together with the start of the power supply frequency determination processing, various settings are read from the setting value storage unit 36.

First, in step 100, an initial voltage determination is performed. The initial voltage determination is, as an example, taken as the timing at which the DC voltage has first entered within the reference voltage range from the power supply frequency determination processing being started.

In the next step 102, a determination is made as to whether or not the next voltage determination time has been reached, and the processing proceeds to step 104 in the case of a positive determination. The case where the next voltage determination time has been reached is the case where the voltage determination time interval has elapsed from the previous voltage determination.

In step 104, a voltage determination for determining whether or not the fluctuating DC voltage enters within the reference voltage range is performed.

For example, in the case where the assumed frequency is 50 Hz, the voltage determination is performed at voltage determination time intervals of 10 msec. The DC voltage fluctuates by the predetermined ripple width, and therefore sometimes enters within the reference voltage range and sometimes does not. In the voltage determination, the number of times that the DC voltage has entered within the reference voltage range (hereinafter, referred to as the "detection count") is counted.

In the next step 106, a determination is made as to whether or not the frequency determination time range has ended, and the processing proceeds to step 110 in the case of a positive determination. However, in the case of a negative determination, the processing returns to step 102, and the voltage determination is repeated until the frequency determination time range ends.

For example, in the case where the assumed frequency is 50 Hz, the voltage determination is performed every 10 msec within a time range of 100 msec. In other words, the voltage determination is performed 10 times.

In step 110, a frequency determination for determining the validity of the assumed frequency is performed.

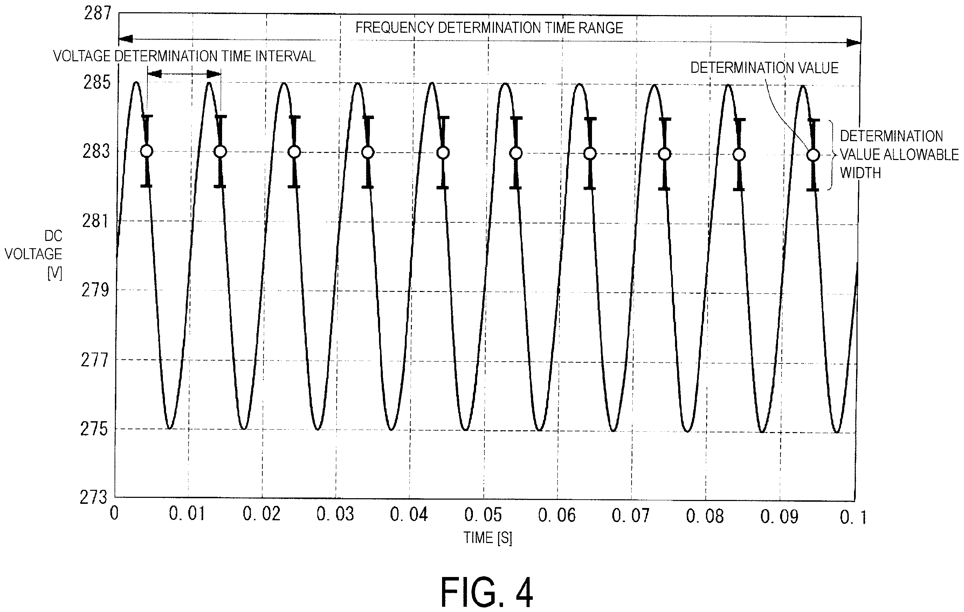

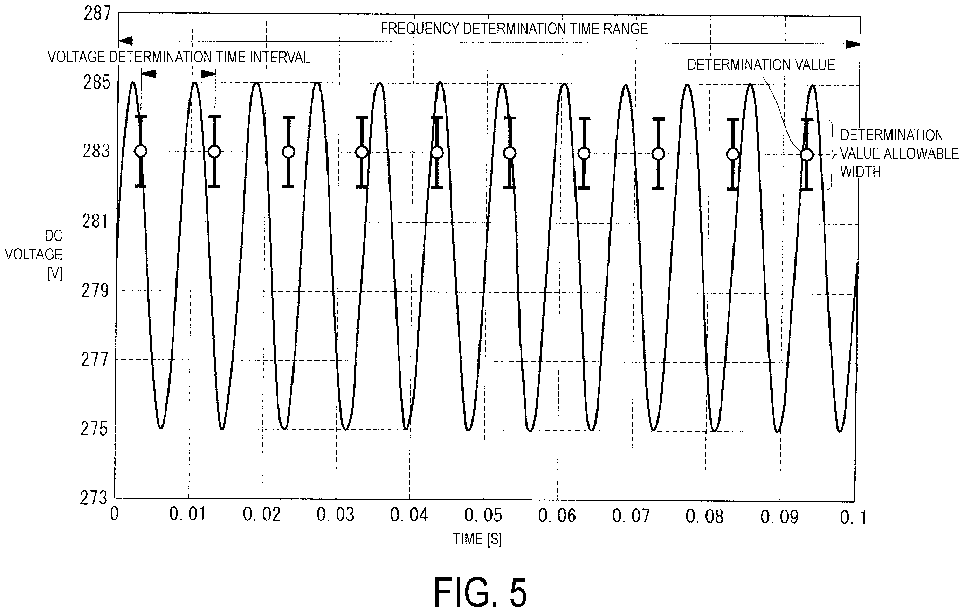

The frequency determination will be described with reference to the examples of FIGS. 4 and 5. FIG. 4 is the case where the assumed frequency taken as 50 Hz and the actual AC power frequency match. FIG. 5 is the case where the assumed frequency has been taken as 50 Hz but the actual AC power frequency was 60 Hz. In other words, FIG. 4 is an example in which the assumed frequency is correct, and FIG. 5 is an example in which the assumed frequency is not correct.

In the case where the assumed frequency is 50 Hz, if the DC voltage enters within the reference voltage range five times or more within the frequency determination time range of 100 msec, it is determined that the assumed frequency is correct and the actual AC power is also 50 Hz. In the example of FIG. 4, the DC voltage enters within the reference voltage range in all of the voltage determinations performed 10 times. However, this is the case where the DC power is fluctuating at an ideal ripple width. The DC voltage does not always fluctuate at an ideal ripple width at each voltage determination. Therefore, there are also cases where the DC voltage does not enter within the reference voltage range even though the assumed frequency is correct.

It should be noted that, when the reference voltage range is wide, the detection count also increases. Therefore, the detection count for which the assumed frequency is treated as being correct is predetermined in accordance with the width of the reference voltage range. In the present embodiment, as described above, as an example, the assumed frequency is determined as being correct in the case where the DC voltage has entered within the reference voltage range five times or more.

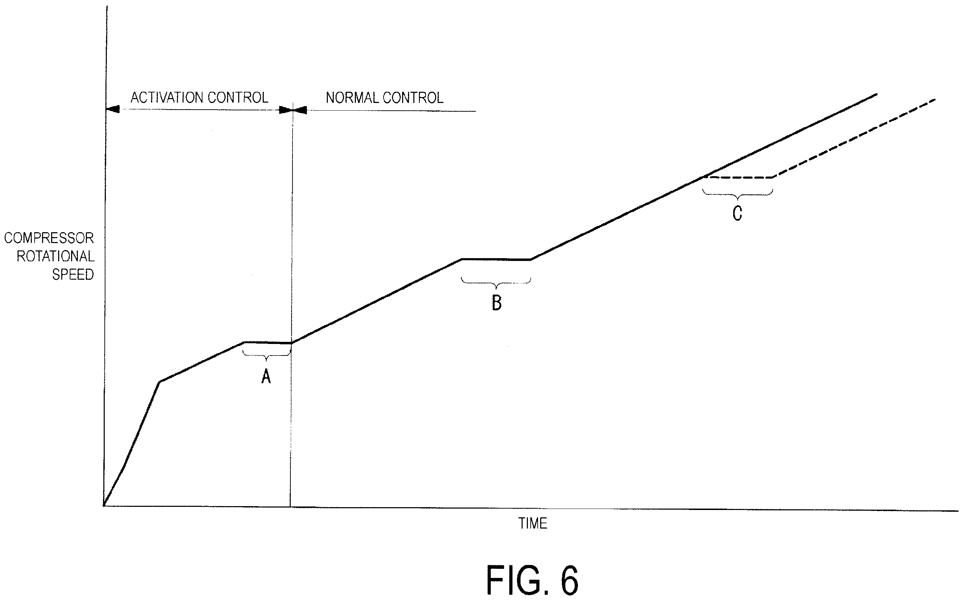

However, as depicted in FIG. 5, the actual AC power is taken as being 60 Hz even though the assumed frequency is taken as 50 Hz. In this case, the number of times that the DC voltage enters within the reference voltage range decreases at voltage determination time intervals for which the assumed frequency is taken as 50 Hz. The reason being because ripples of the DC voltage fluctuate at cycles of 60 Hz, and therefore, as depicted in FIG. 6, the cycles of the voltage determination time intervals and the fluctuation cycles of the ripples of the DC voltage deviate. Therefore, the detection count becomes less than the number of times with which the assumed frequency is taken as being correct, and the AC power is determined as not being 50 Hz.

It should be noted that the timings for the voltage determination in both FIGS. 4 and 5 are implemented at timings at which the DC voltage falls, but there is no restriction thereto, and this may be performed at timings at which the DC voltage rises.

In this way, in the power supply frequency determination processing, voltage determination is performed within the frequency determination time range at each voltage determination time interval corresponding to the assumed frequency. Also, in the power supply frequency determination processing, the validity of the assumed frequency is determined based on the detection count for the number of times that a DC voltage has entered within the reference voltage range. Consequently, in the power supply frequency determination processing, the frequency of AC power can be determined without separately providing a frequency detection circuit.

Furthermore, the power supply device 10 may be provided with a conventional frequency detection circuit that detects the frequency of AC power by measuring zero-cross intervals of the AC power, and the accuracy of the frequency determination for AC power may be improved by combined use with the frequency detection circuit.

Furthermore, in the case where the assumed frequency is determined as not being correct, a different frequency may be set as the assumed frequency, and the power supply frequency determination processing may be performed again.

FIG. 6 is a drawing depicting frequency determination timings.

The power supply frequency determination processing is performed while the rotational speed of the compressor 12 is made constant.

In the case where the rotational speed of the compressor 12 is constant, rising or falling of the input voltage to the motor 14 provided in the compressor 12 does not occur, and the input current is also in a stable state. Therefore, in the power supply frequency determination processing, the frequency of the AC power can be determined more accurately.

It should be noted that, for the determination of the frequency, a state in which the input current to the motor 14 is low is preferable. The reason being because, since the power consumption of the compressor 12 is low, the power consumption of the power supply frequency determination processing can be reduced.

For example, it is preferable that the power supply frequency determination processing be performed in period A depicted in FIG. 6. Period A is a period for activation control for the compressor 12, and is a period in which the rotational speed, prior to normal control in which rotational speed control is performed according to the load, is constant.

Furthermore, even in the normal control, the power supply frequency determination processing may be performed in a period during which the rotational speed is made constant for the purpose of other control changes as indicated in period B.

Furthermore, even in the normal control, a period during which the rotational speed is made constant in order to perform the power supply frequency determination processing as indicated in period C may be provided.

Hereinabove, the present invention has been described using the aforementioned embodiment; however, the technical scope of the present invention is not restricted to the scope described in the aforementioned embodiment.

For example, in the aforementioned embodiment, a description has been given regarding a mode in which the present invention is applied to the air conditioner control device 26 of the power supply device 10 that supplies power to the motor 14 of the compressor 12. However, the present invention is not restricted thereto, and a mode in which the present invention is applied to another device in which it is necessary to determine the frequency of AC power is also permissible.

For example, in the aforementioned embodiment, a description has been given regarding a mode in which the assumed frequency is taken as 50 Hz or 60 Hz. However, the present invention is not restricted thereto, and a mode in which the assumed frequency is taken as another frequency is also permissible.

### Reference Signs List

10 Power supply device
12 Compressor
14 Motor
20 Converter
24 Voltage detection unit
26 Air conditioner control device
32 Voltage determination unit
34 Frequency determination unit

## Claims

1. A power supply frequency determination device, comprising:
a voltage detection means (24) configured to detect a DC voltage converted from AC power by a converter (20);
a voltage determination means (32) configured to determine whether or not the DC voltage detected by the voltage detection means (24) enters within a predetermined reference voltage range, at time intervals corresponding to an assumed value for a frequency of the AC power; and
a frequency determination means (34) configured to determine a validity of the assumed value, based on a number of times that the DC voltage is determined as having entered within the reference voltage range by the voltage determination means (32), within a time range corresponding to the assumed value.

2. The power supply frequency determination device according to claim 1, wherein
the reference voltage range is a range for which a predetermined reference voltage is taken as a determination value, and an allowable width of the determination value is taken as a predetermined ratio of a ripple width of the DC voltage.

3. The power supply frequency determination device according to claim 1 or claim 2, wherein
the voltage detection means (24) is provided between the converter (20) configured to convert the AC power into DC power and an inverter (22) configured to convert and to supply the DC power to a motor (14), and
the voltage determination means (32) is configured to perform a determination while a rotational speed of the motor is made constant.

4. A power supply frequency determination method, comprising:
a first step in which a DC voltage converted from AC power by a converter (20) is detected;
a second step in which whether or not the detected DC voltage enters within a predetermined reference voltage range is determined at time intervals corresponding to an assumed value for a frequency of the AC power; and
a third step in which a validity of the assumed value is determined based on a number of times that the detected DC voltage is determined to have entered within the reference voltage range, within a time range corresponding to the frequency.

## Patentansprüche

1. Energieversorgungsfrequenz-Bestimmungsvorrichtung, aufweisend:
eine Spannungserfassungseinrichtung (24), die konfiguriert ist, um eine Gleichspannung zu erfassen, die durch einen Umwandler (20) aus einer Wechselspannung umgewandelt ist;
eine Spannungsbestimmungseinrichtung (32), die konfiguriert ist, um zu Zeitintervallen korrespondierend zu einem angenommenen Wert für eine Frequenz der Wechselspannung zu bestimmen, ob die durch die Spannungserfassungseinrichtung (24) erfasste Gleichspannung innerhalb eines vorbestimmten Bezugsspannungsbereichs liegt oder nicht; und
eine Frequenzbestimmungseinrichtung (34), die konfiguriert ist, um innerhalb eines Zeitbereichs korrespondierend zu dem angenommenen Wert eine Gültigkeit des angenommenen Werts basierend auf einer Häufigkeit zu bestimmen, dass die Gleichspannung durch die Spannungsbestimmungseinrichtung (32) als in dem Bezugsspannungsbereich liegend bestimmt ist.

2. Energieversorgungsfrequenz-Bestimmungsvorrichtung nach Anspruch 1, wobei
der Bezugsspannungsbereich ein Bereich ist, für welchen eine vorbestimmte Bezugsspannung als ein Bestimmungswert angenommen ist, und eine zulässige Breite des Bestimmungswerts als ein vorbestimmtes Verhältnis einer Welligkeitsbreite der Gleichspannung angenommen ist.

3. Energieversorgungsfrequenz-Bestimmungsvorrichtung nach Anspruch 1 oder 2, wobei
die Spannungserfassungseinrichtung (24) zwischen dem Umwandler (20), der konfiguriert ist, um die Wechselspannung in eine Gleichspannung umzuwandeln, und einem Wechselrichter (22), der konfiguriert ist, um die Gleichspannung umzuwandeln und sie einem Motor (14) zuzuführen, vorgesehen ist, und
die Spannungsbestimmungseinrichtung (32) konfiguriert ist, um eine Bestimmung durchzuführen, während eine Drehgeschwindigkeit des Motors konstant gehalten wird.

4. Energieversorgungsfrequenz-Bestimmungsverfahren, aufweisend:
einen ersten Schritt, in welchem eine Gleichspannung, die durch einen Umwandler (20) aus einer Wechselspannung umgewandelt ist, erfasst wird;
einen zweiten Schritt, in welchem zu Zeitintervallen korrespondierend zu einem angenommenen Wert für eine Frequenz der Wechselspannung bestimmt wird, ob die erfasste Gleichspannung innerhalb eines vorbestimmten Bezugsspannungsbereichs liegt oder nicht; und
einen dritten Schritt, in welchem innerhalb eines Zeitbereichs korrespondierend zu der Frequenz eine Gültigkeit des angenommenen Werts basierend auf einer Häufigkeit bestimmt wird, dass die erfasste Gleichspannung als innerhalb des Bezugsspannungsbereichs liegend bestimmt ist.

## Revendications

1. Dispositif de détermination de fréquence d'alimentation, comprenant :
des moyens de détection de tension (24) configurés pour détecter une tension continue obtenue par la conversion d'une puissance alternative par un convertisseur (20) ;
des moyens de détermination de tension (32) configurés pour déterminer si, oui ou non, la tension continue détectée par les moyens de détection de tension (24) entre dans une plage de tension de référence prédéterminée, à des intervalles de temps correspondant à une valeur supposée pour une fréquence de la puissance alternative ; et
des moyens de détermination de fréquence (34) configurés pour déterminer une validité de la valeur supposée, sur la base d'un nombre de fois où il est déterminé que la tension continue est entrée dans la plage de tension de référence par les moyens de détermination de tension (32), dans une plage de temps correspondant à la valeur supposée.

2. Dispositif de détermination de fréquence d'alimentation selon la revendication 1, dans lequel
la plage de tension de référence est une plage pour laquelle une tension de référence prédéterminée est prise en tant que valeur de détermination, et une largeur admissible de la valeur de détermination est prise en tant que rapport prédéterminé d'une largeur d'ondulation de la tension continue.

3. Dispositif de détermination de fréquence d'alimentation selon la revendication 1 ou la revendication 2, dans lequel
les moyens de détection de tension (24) sont prévus entre le convertisseur (20) configuré pour convertir la puissance alternative en une puissance continue et un onduleur (22) configuré pour convertir et pour fournir la puissance continue à un moteur (14), et
les moyens de détermination de tension (32) sont configurés pour effectuer une détermination alors qu'une vitesse de rotation du moteur est établie à une valeur constante.

4. Procédé de détermination de fréquence d'alimentation, comprenant :
une première étape à laquelle une tension continue obtenue par la conversion d'une puissance alternative par un convertisseur (20) est détectée ;
une deuxième étape à laquelle il est déterminé si, oui ou non, la tension continue détectée entre dans une plage de tension de référence prédéterminée à des intervalles de temps correspondant à une valeur supposée pour une fréquence de la puissance alternative ; et
une troisième étape à laquelle une validité de la valeur supposée est déterminée sur la base d'un nombre de fois où il est déterminé que la tension continue détectée est entrée dans la plage de tension de référence, dans une plage de temps correspondant à la fréquence.
